# EUROPÄISCHE PATENTSCHRIFT

(11) **EP 2 340 575 B1**
(45) Veröffentlichungstag und Bekanntmachung des Hinweises auf die Patenterteilung: **13.02.2013**
(21) Anmeldenummer: 09744623.1
(22) Anmeldetag: 20.10.2009
(51) Int. Cl.: H01L 41/193, H01L 41/45

(54) **ENERGIEWANDLER AUF BASIS VON POLYURETHAN-LÖSUNGEN**
ENERGY CONVERTER BASED ON POLYURETHANE SOLUTIONS
CONVERTISSEUR D'ÉNERGIE À BASE DE SOLUTIONS DE POLYURÉTHANE

(30) Priorität: 30.10.2008 EP 08018936
(43) Veröffentlichungstag der Anmeldung: 06.07.2011
(73) Patentinhaber: Bayer MaterialScience AG, 51368 Leverkusen (DE)
(72) Erfinder: JENNINGER, Werner, 50677 Köln (DE); DÖRR, Sebastian, 40593 Düsseldorf (DE); WAGNER, Joachim, 51061 Köln (DE)
(86) Internationale Anmeldenummer: PCT/EP2009/007489
(87) Internationale Veröffentlichungsnummer: WO 2010/049079

(56) Entgegenhaltungen:
- WO-A1-01/06575
- WO-A1-2006/027544
- WO-A1-2006/089648
- WO-A1-2007/115697
- KR-A- 20030 006 483

## Beschreibung

Die vorliegende Erfindung betrifft ein Verfahren zur Herstellung elektromechanischer Wandler, die Verwendung von Lösungen von wenigstens einem Polyurethan in einem oder mehreren organischen Lösungsmitteln zur Herstellung elektromechanischer Wandler, daraus hergestellte elektromechanische Wandler und die Anwendung derartiger elektromechanischer Wandler.

Wandler - auch elektromechanische Wandler genannt - wandeln elektrische Energie in mechanische Energie um und umgekehrt. Sie können als Bestandteil von Sensoren, Aktuatoren und Generatoren eingesetzt werden.

Der grundsätzliche Aufbau eines solchen Wandlers besteht aus einer Schicht des elektroaktiven Polymeren, welche beidseitig mit Elektroden beschichtet ist, wie beispielsweise in WO-A 01/06575 beschrieben. Dieser grundsätzliche Aufbau kann in unterschiedlichsten Konfigurationen zur Herstellung von Sensoren, Aktuatoren oder Generatoren eingesetzt werden.

Im Stand der Technik sind Wandler beschrieben, welche verschiedene Polymere als Bestandteil der elektroaktiven Schicht enthalten, siehe beispielsweise in WO-A 01/06575.

In KR 2003 0006483 A wird ein Verfahren zur Herstellung eines Wandlers zur Umwandlung elektrischer in mechanische Energie und umgekehrt durch Herstellung einer Polyurethanschicht zwischen zwei Elektroden durch Verdampfen des Lösungsmittels einer Polyurethanpolymer enthaltenden Lösung. Bei dem in KR 2003 0006483 A beschriebenen Verfahren wird nach dem Verdampfen des Lösungsmittels die Temperatur erhöht und auf der Glasübergangstemperatur des Polyurethans gehalten.

Die Verwendung solcher Polymerlösungen als Ausgangsbasis zur Herstellung von elastischen, elektroaktiven Schichten in Wandlern weist verschiedene Vorteile auf, insbesondere sind sie einfach zu handhaben und können im Allgemeinen bei Temperaturen zwischen Raumtemperatur und 100°C verarbeitet werden, so dass auch temperaturempfindliche Substrate beschichtbar sind. Weiterhin ist in der Regel eine einkomponentige Verarbeitung möglich.

Aufgabe der vorliegenden Erfindung war daher die Bereitstellung von neuen elastischen isolierenden elektroaktiven Schichten für elektromechanische Wandler, welche vorteilhafte Eigenschaften aufweisen. Insbesondere sollen sie eine einfache Verarbeitung ermöglichen und vorteilhafte mechanische Eigenschaften aufweisen.

Es wurde nun gefunden, dass filmbildende Zusammensetzungen auf Basis von Lösungen wenigstens eines Polyurethans in einem oder mehreren organischen Lösungsmitteln sich gut zur Herstellung von elastischen, elektroaktiven Schichten für elektromechanische Wandler mit hohem spezifischen Volumenwiderstand im Bereich von mehr als 10¹² Ohm·cm eignen. Solche Lösungen lassen sich einfach verarbeiten und der Einsatz von Mehrkomponentensystemen bei der Herstellung der Schichten kann vermieden werden. Überraschend zeigen so hergestellte Schichten hervorragende mechanische Eigenschaften und eine geringe Wasseraufnahmefähigkeit.

Bei einer hohen Wasseraufnahmefähigkeit kann Wasser beispielsweise als Weichmacher agieren und das mechanische Profil der eingesetzten Werkstoffe verändern. Weiterhin ist auch die elektrische Isolation der Elektroden durch das Polymer bei einer hohen Wasseraufnahme und einer sehr hohen, anliegenden (elektrischen) Spannung nicht mehr zwangsläufig gewährleistet. Diese Nachteile können durch die überraschend geringe Wasseraufnahmefähigkeit vermieden werden. Die geringe Wasseraufnahmefähigkeit bietet insbesondere den Vorteil, dass die Funktion des elektromechanischen Wandlers unabhängig von der Luftfeuchtigkeit gegeben ist.

Gegenstand der vorliegenden Erfindung ist daher ein Verfahren zur Herstellung eines Wandlers zur Umwandlung von elektrischer Energie in mechanische Energie oder von mechanischer Energie in elektrische Energie nach Anspruch 1, welcher mindestens zwei Elektroden und wenigstens eine zwischen den Elektroden angeordnete Polymerschicht aufweist, wobei die Polymerschicht aus einer Lösung enthaltend wenigstens ein Polyurethan in einem oder mehreren organischen Lösungsmitteln hergestellt wird, wobei die Lösung aus einem Prepolymerisationsverfahren mit folgenden Schritten stammt:
A) Herstellen von isocyanatfunktionellen Prepolymeren aus
   A1) organischen Polyisocyanaten,
   A2) polymeren Polyolen und
   A3) gegebenenfalls hydroxyfunktionellen Verbindungen und
B) ganz oder teilweises Umsetzen der freien NCO-Gruppen des Prepolymeren aus A) mit
   B1) aminofunktionellen Verbindungen,
wobei die Prepolymere vor, während und/oder nach Schritt B) in einem oder mehreren organischen Lösungsmitteln gelöst werden.

Gegenstand der vorliegenden Erfindung ist weiterhin die Verwendung einer Lösung enthaltend wenigstens ein Polyurethan in einem oder mehreren organischen Lösungsmitteln zur Herstellung eines Wandlers zur Umwandlung von elektrischer Energie in mechanische Energie oder von mechanischer Energie in elektrische Energie, welcher mindestens zwei Elektroden und eine zwischen den Elektroden angeordnete Polymerschicht aufweist, dadurch gekennzeichnet, dass die Polymerschicht aus der Lösung enthaltend wenigstens ein Polyurethan in einem oder mehreren organischen Lösungsmitteln hergestellt wird.

Gegenstand der vorliegenden Erfindung ist weiterhin ein Wandler zur Umwandlung von elektrischer Energie in mechanische Energie oder von mechanischer Energie in elektrische Energie nach Anspruch 8 welcher mindestens zwei Elektroden und eine zwischen den Elektroden angeordnete Polymerschicht aufweist, dadurch gekennzeichnet, dass die Polymerschicht aus einer Lösung enthaltend wenigstens ein Polyurethan in einem oder mehreren organischen Lösungsmitteln hergestellt wird.

Die Lösung enthaltend wenigstens ein Polyurethan in einem oder mehreren organischen Lösungsmitteln zur Herstellung der Polymerschicht wird im Folgenden auch als filmbildende Zusammensetzung oder kurz als Polyurethan-Lösung bezeichnet.

Bei der Polymerschicht, welche erfindungsgemäß aus einer Lösung enthaltend wenigstens ein Polyurethan in einem oder mehreren organischen Lösungsmitteln hergestellt wird, handelt es sich um die elektroaktive Schicht oder einen Teil der elektroaktiven Schicht eines elektromechanischen Wandlers.

Prinzipiell können alle bekannten Polyurethan-Lösungen als zu verwendende filmbildende Zusammensetzungen eingesetzt werden.

Besonders bevorzugt einzusetzende Polyurethan-Lösungen sind erhältlich nach einem Prepolymerisationverfahren, indem
A) isocyanatfunktionelle Prepolymere aus
   A1) organischen Polyisocyanaten
   A2) polymeren Polyolen mit zahlenmittleren Molekulargewichten von 400 bis 8000 g/mol, vorzugsweise 400 bis 6000 g/mol und besonders bevorzugt von 600 bis 3000 g/mol, und OH-Funktionalitäten von 1,5 bis 6, bevorzugt 1,8 bis 3, besonders bevorzugt von 1,9 bis 2,1, und
   A3) gegebenenfalls hydroxyfunktionellen Verbindungen mit Molekulargewichten von 62 bis 399 g/mol
   hergestellt werden, und
B) die freien NCO-Gruppen der Prepolymeren aus A) dann ganz oder teilweise mit
   B1) aminofunktionellen Verbindungen mit Molekulargewichten von 32 bis 1000 g/mol, bevorzugt 32 bis 400 g/mol
   unter Kettenverlängerung umgesetzt werden,
wobei die Prepolymere vor, während oder nach Schritt B) in einem oder mehreren organischen Lösungsmitteln gelöst werden.

Bevorzugt besitzen die erfindungsgemäß zu verwendenden Polyurethan-Lösungen Feststoffgehalte von 5 bis 70 Gew.-%, besonders bevorzugt 15 bis 60 Gew.-%, ganz besonders bevorzugt 20 bis 40 Gew.-% bezogen auf das Gesamtgewicht der Polyurethan-Lösung.

Geeignete Polyisocyanate der Komponente A1) sind die dem Fachmann an sich bekannten aliphatischen, aromatischen oder cycloaliphatischen Polyisocyanate einer NCO-Funktionalität von größer oder gleich 2.

Beispiele solcher geeigneten Polyisocyanate sind 1,4-Butylendiisocyanat, 1,6-Hexamethylendiisocyanat (HDI), Isophorondiisocyanat (IPDI), 2,2,4- und/oder 2,4,4-Trimethylhexamethylendiisocyanat, die isomeren Bis-(4,4`-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantrüsocyanat), 1,4-Phenylendiisocyanat, 2,4- und/oder 2,6-Toluylendiisocyanat, 1,5-Naphthylendiisocyanat, 2,2'-und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanato-methyl)benzol (XDI) sowie Alkyl-2,6-diisocyanatohexanoate (Lysindiisocyanate) mit C1-C8-Alkylgruppen.

Neben den vorstehend genannten Polyisocyanaten können auch modifizierte Diisocyanate die eine Funktionalität ≥ 2 aufweisen, mit Uretdion-, Isocyanurat-, Urethan-, Allophanat-, Biuret-, Iminooxadiazindion- oder Oxadiazintrionstruktur sowie Mischungen aus diesen anteilig eingesetzt werden.

Bevorzugt handelt es sich um Polyisocyanate oder Polyisocyanatgemische der vorstehend genannten Art mit ausschließlich aliphatisch oder cycloaliphatisch gebundenen Isocyanatgruppen oder Mischungen aus diesen und einer mittleren NCO-Funktionalität der Mischung von 2 bis 4, bevorzugt 2 bis 2,6 und besonders bevorzugt 2 bis 2,4. In ganz besonders bevorzugten Ausführungsformen handelt es sich um difunktionelle Isocyanatbausteine, bevorzugt difunktionelle aliphatische Isocyanatbausteine.

Besonders bevorzugt werden in A1) Hexamethylendiisocyanat, Isophorondiisocyanat oder die isomeren Bis-(4,4`-isocyanatocyclohexyl)methane sowie Mischungen der vorgenannten Diisocyanate eingesetzt. In einer ganz besonders bevorzugten Ausführungsform wird eine Mischung aus Hexamethylendiisocyanat und Isophorondiisocyanat eingesetzt.

In A2) werden polymere Polyole mit einem zahlenmittleren Molekulargewicht Mₙ von 400 bis 8000 g/mol, bevorzugt von 400 bis 6000 g/mol und besonders bevorzugt von 600 bis 3000 g/mol eingesetzt. Diese weisen bevorzugt eine OH-Funktionalität von 1,5 bis 6, besonders bevorzugt von 1,8 bis 3, ganz besonders bevorzugt von 1,9 bis 2,1 auf.

Solche polymeren Polyole sind die in der Polyurethanlacktechnologie an sich bekannten Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und Polyesterpolycarbonatpolyole. Diese können in A2) einzeln oder in beliebigen Mischungen untereinander eingesetzt werden.

Geeignete Polyesterpolyole sind die an sich bekannten Polykondensate aus Di- sowie gegebenenfalls Tri- und Tetraolen und Di- sowie gegebenenfalls Tri- und Tetracarbonsäuren oder Hydroxycarbonsäuren oder Lactonen. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimetylolbenzol oder Trishydroxyethylisocyanurat eingesetzt werden.

Als Dicarbonsäuren können Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dimethylbernsteinsäure eingesetzt werden. Als Säurequelle können auch die entsprechenden Anhydride verwendet werden.

Sofern die mittlere Funktionalität des zu veresternden Polyols > als 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure, Hydroxystearinsäure und dergleichen. Geeignete Lactone sind Caprolacton, Butyrolacton und Homologe. Bevorzugt ist Caprolacton.

Geeignete Polycarbonatpolyole sind hydroxylgruppenaufweisende Polycarbonate, bevorzugt Polycarbonatdiole, mit zahlenmittleren Molekulargewichten Mₙ von 400 bis 8000 g/mol, bevorzugt 600 bis 3000 g/mol. Diese sind durch Reaktion von Kohlensäurederivaten, wie Diphenylcarbonat, Dimethylcarbonat oder Phosgen, mit Polyolen, bevorzugt Diolen, erhältlich.

Beispiele derartiger Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A und lactonmodifizierte Diole der vorstehend genannten Art.

Bevorzugt enthält die Diolkomponente 40 bis 100 Gew.-% Hexandiol, bevorzugt sind 1,6-Hexandiol und/oder Hexandiolderivate. Solche Hexandiolderivate basieren auf Hexandiol und weisen neben endständigen OH-Gruppen Ester- oder Ethergruppen auf. Solche Derivate sind durch Reaktion von Hexandiol mit überschüssigem Caprolacton oder durch Veretherung von Hexandiol mit sich selbst zum Di- oder Trihexylenglykol erhältlich.

Statt oder zusätzlich zu reinen Polycarbonatdiolen können auch Polyether-Polycarbonatdiole in A2) eingesetzt werden.

Hydroxylgruppen aufweisende Polycarbonate sind bevorzugt linear gebaut.

Geeignete Polyetherpolyole sind beispielsweise die in der Polyurethanchemie an sich bekannten Polytetramethylenglykolpolyether wie sie durch Polymerisation von Tetrahydrofuran mittels kationischer Ringöffnung erhältlich sind.

Als geeignete Startermoleküle können alle dem Stand der Technik nach bekannten Verbindungen eingesetzt werden, wie zum Beispiel Wasser, Butyldiglykol, Glycerin, Diethylenglykol, Trimethyolpropan, Propylenglykol, Sorbit, Ethylendiamin, Triethanolamin, 1,4-Butandiol.

Bevorzugte Komponenten in A2) sind Polytetramethylenglykolpolyether und PolycarbonatPolyole bzw. deren Mischungen und besonders bevorzugt sind Polytetramethylenglykolpolyether.

In A3) können Polyole des genannten Molekulargewichtsbereichs mit bis zu 20 Kohlenstoffatomen, wie Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin, Pentaerythrit sowie deren beliebige Mischungen untereinander eingesetzt werden.

Geeignet sind auch Esterdiole des genannten Molekulargewichtsbereichs wie α-Hydroxybutyl-ε-hydroxy-capronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können in A3) auch monofunktionelle isocyanatreaktive Hydroxyl-gruppenhaltige Verbindungen eingesetzt werden. Beispiele solcher monofunktionellen Verbindungen sind Methanol, Ethanol, iso-Propanol, n-Propanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol, 1-Hexadecanol. Falls derartige Alkohole mit dem Isocyanat-funktionellen Prepolymer regieren, werden die entsprechend abreagierten Anteile nicht mehr zu den Lösemitteln dazugezählt.

Als Komponente B1) können organische Di- oder Polyamine wie beispielsweise 1,2-Ethylendiamin, 1,2- und 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, 4,4-Diaminodicyclohexylmethan, Hydrazinhydrat, und/oder Dimethylethylendiamin eingesetzt werden.

Darüber hinaus können als Komponente B1) auch Verbindungen, die neben einer primären Aminogruppe auch sekundäre Aminogruppen oder neben einer Aminogruppe (primär oder sekundär) auch OH-Gruppen aufweisen, eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamins wie N-Aminoethylethanolamin, Ethanolamin, 3-Aminopropanol, Neopentanolamin.

Ferner können als Komponente B1) auch monofunktionelle isocyanatreaktive Aminverbindungen eingesetzt werden, wie beispielsweise Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)-aminopropylamin, Morpholin, Piperidin, bzw. geeignete substituierte Derivate davon, Amidamine aus diprimären Aminen und Monocarbonsäuren, Monoketim von diprimären Aminen, primär/tertiäre Amine, wie N,N-Dimethylaminopropylamin.

Bevorzugt werden 1,2-Ethylendiamin, Bis(4-aminocyclohexyl)methan, 1,4-Diaminobutan, Isophorondiamin, Ethanolamin, Diethanolamin und Diethylentriamin eingesetzt.

Bevorzugt werden die Bausteine A1), A2), A3) und B1) so gewählt, dass kein oder nur ein geringer Anteil an Verzweigungsstellen in dem Polyurethan gebildet wird, da ansonsten eine hohe Lösungsviskosität resultiert. Besonders bevorzugt werden ausschließlich Bausteine mit einer mittleren Funktionalität < 2,2 eingesetzt, ganz besonders bevorzugt mit einer mittleren Funktionalität < 2,05. In einer besonders bevorzugten Ausführungsform werden ausschließlich difunktionelle und monofunktionelle Bausteine eingesetzt und in einer ganz besonders bevorzugten Ausführungsform werden ausschließlich difunktionelle Bausteine eingesetzt.

In einer bevorzugten Ausführungsform zur Herstellung der speziellen Polyurethan-Lösungen werden die Komponenten A1) bis A3) und B1) in den folgenden Mengen zur Herstellung des Polyurethans eingesetzt, d.h. in das Polyurethan eingebaut, wobei sich die Einzelmengen stets zu 100 Gew.-% aufaddieren:
5 bis 40 Gew.-% Komponente A1),
55 bis 90 Gew.-% Komponente A2),
0 bis 10 Gew.-% Komponente A3) und
1 bis 15 Gew.-% Komponente B1).

In einer besonders bevorzugten Ausführungsform zur Herstellung der speziellen Polyurethan-Lösungen werden die Komponenten A1) bis A3) und B1) in den folgenden Mengen zur Herstellung des Polyurethans eingesetzt, d.h. in das Polyurethan eingebaut, wobei sich die Einzelmengen stets zu 100 Gew.-% aufaddieren:
5 bis 35 Gew.-% Komponente A1),
60 bis 85 Gew.-% Komponente A2),
0 bis 5 Gew.-% Komponente A3) und
3 bis 10 Gew.-% Komponente B1).

In einer ganz besonders bevorzugten Ausführungsform zur Herstellung der speziellen Polyurethan-Lösungen werden die Komponenten A1) bis A3) und B1) in den folgenden Mengen zur Herstellung des Polyurethans eingesetzt, d.h. in das Polyurethan eingebaut, wobei sich die Einzelmengen stets zu 100 Gew.-% aufaddieren:
10 bis 30 Gew.-% Komponente A1),
65 bis 85 Gew.-% Komponente A2),
0 bis 3 Gew.-% Komponente A3) und
3 bis 8 Gew.-% Komponente B1).

Die vorangehend aufgeführten Mengen der einzelnen Komponenten A1), A2), A3) und B1) bezeichnen die zum Aufbau des Polyurethans eingesetzten Mengen und berücksichtigen nicht zusätzliche Mengen dieser Komponenten, die gegebenenfalls als Lösungsmittel vorhanden sind bzw. zugegeben werden.

Vor, während oder nach vollständig oder teilweise durchgeführter Polyaddition aus A1), A2) und gegebenenfalls A3) kann ein Lösungsschritt erfolgen. Auch während oder nach Zugabe von B1) kann ein Lösungsschritt erfolgen. Es sind Mischungen aus wenigstens zwei organischen Lösungsmitteln einsetzbar oder nur ein organisches Lösungsmittel. Bevorzugt sind Mischungen aus Lösungsmitteln.

Für die Herstellung der Polyurethan-Lösungen werden bevorzugt die Bestandteile A1), A2) und gegebenenfalls A3) zur Herstellung eines isocyanatfunktionellen Polyurethan-Prepolymers ganz oder teilweise vorgelegt, gegebenenfalls mit einem gegenüber Isocyanat-gruppen inerten Lösungsmittel verdünnt und auf Temperaturen im Bereich von 50 bis 120°C aufgeheizt. Zur Beschleunigung der Isocyanatadditionsreaktion können die in der Polyurethan-Chemie bekannten Katalysatoren eingesetzt werden.

Anschließend werden die gegebenenfalls zu Beginn der Reaktion noch nicht zugegebenen Bestandteile von A1), A2) und gegebenenfalls A3) zudosiert.

Bei der Herstellung des Polyurethan-Prepolymeren aus A1), A2) und gegebenenfalls A3) beträgt das Stoffmengenverhältnis von Isocyanat-Gruppen zu isocyanatreaktiven Gruppen im allgemeinen 1,05 bis 3,5, bevorzugt 1,1 bis 3,0, besonders bevorzugt 1,1 bis 2,5.

Unter isocyanatreaktiven Gruppen sind alle gegenüber Isocyanat-Gruppen reaktiven Gruppen zu verstehen, wie beispielsweise primäre und sekundäre Aminogruppen, Hydroxygruppen oder Thiolgruppen.

Die Umsetzung der Komponenten A1), A2) und gegebenenfalls A3) zum Prepolymer erfolgt teilweise oder vollständig, bevorzugt aber vollständig. Es werden so Polyurethan-Prepolymere, die freie Isocyanatgruppen enthalten, in Substanz oder in Lösung erhalten.

Im Anschluss wird in einem weiteren Verfahrensschritt, falls noch nicht oder nur teilweise geschehen, das erhaltene Prepolymer mit Hilfe von einem oder mehreren organischen Lösemitteln gelöst.

Bei der Kettenverlängerung in Stufe B) werden NH₂- und/oder NH-funktionelle Komponenten mit den noch verbliebenen Isocyanatgruppen des Prepolymers umgesetzt.

Der Kettenverlängerungsgrad, also das Äquivalentverhältnis von NCO-reaktiven Gruppen der zur Kettenverlängerung und Kettenterminierung eingesetzten Verbindungen unter B) zu freien NCO-Gruppen des unter A) hergestellten Prepolymers, liegt im allgemeinen zwischen 50 und 150 %, bevorzugt zwischen 50 und 120 %, besonders bevorzugt zwischen 60 und 110 % und ganz besonders bevorzugt um 100%.

Die aminischen Komponenten B1) können gegebenenfalls in lösungsmittelverdünnter Form im erfindungsgemäßen Verfahren einzeln oder in Mischungen eingesetzt werden, wobei grundsätzlich jede Reihenfolge der Zugabe möglich ist. Auch alkoholische Lösemittel können zur Kettenverlängerung oder Kettenterminierung eingesetzt werden. Dabei wird in der Regel nur ein Teil der enthaltenen alkoholischen Lösemittel in die Polymerkette eingebaut.

Wenn organische Lösungsmittel als Verdünnungsmittel mit verwendet werden, so beträgt der Verdünnungsmittelgehalt in der in B) eingesetzten Komponente zur Kettenverlängerung bevorzugt 1 bis 95 Gew.-%, besonders bevorzugt 3 bis 50 Gew.%, bezogen auf das Gesamtgewicht der Komponente B1) einschließlich Verdünnungsmittel.

Typischerweise enthalten die erfindungsgemäßen filmbildenden Zusammensetzungen mindestens 5 Gew.-% Polyurethan, bezogen auf den Feststoffanteil aller in der Zusammensetzung enthaltenen Komponenten, d.h. bezogen auf den Gesamtfeststoffgehalt. Bevorzugt sind jedoch mindestens 30 Gew.-%, besonders bevorzugt mindestens 60 Gew.-%, und ganz besonders bevorzugt 70 bis 99 Gew.-% Polyurethan bezogen auf den Gesamtfeststoffgehalt enthalten.

Geeignete Lösungsmittel für die erfindungsgemäßen Polyurethan-Lösungen sind beispielsweise Ester, wie z.B. Ethylacetat oder Methyoxypropylacetat oder Butyrolacton, Alkohole, wie z.B. Methanol, Ethanol, n-Propanol oder Isopropanol, Ketone, wie z.B. Aceton oder Methylethylketon, Ether, wie z.B. Tetrahydrofuran oder tert.-Butylmethylether, aromatische Lösungsmittel, wie z.B. Toluol, Xylol oder Solvent Naphtha, oder Amid- bzw. Harnstoffgruppen-haltige Lösungsmittel, wie z.B. Dimethylformamid oder N-Methylpyrrolidinon. Bevorzugt werden Ester, Alkohole, Ketone und/oder Ether eingesetzt. Besonders bevorzugt ist zumindest ein Alkohol, bevorzugt zumindest ein aliphatischer Alkohol, besonders bevorzugt zumindest ein aliphatischer Alkohol mit 1 bis 6 Kohlenstoffatomen, wie beispielsweise Methanol, Ethanol, n-Propanol und/oder Isopropanol enthalten und zumindest ein weiteres Lösemittel ausgewählt aus den Gruppen der Ester, Ketone oder Ether. Der besonders bevorzugte Gehalt alkoholischer Lösungsmittel beträgt 10 bis 80 Gew.%, ganz besonders bevorzugt 25 bis 65 Gew.%, bezogen auf das Gesamtgewicht aller Lösungsmittel. Alkohole werden im Rahmen der Erfindung als Lösungsmittel bezeichnet, solange sie nach Ausbildung des isocyanatfunktionellen Prepolymeren zugegeben werden. Der Anteil von Alkoholen, der als hydroxyfunktionelle Verbindung A3) bei der Herstellung des isocyanatfunktionellen Prepolymeren eingesetzt und in dieses kovalent eingebaut wird, zählt nicht zu den Lösungsmitteln.

Bevorzugt enthält die erfindungsgemäß zu verwendende Lösung von wenigstens einem Polyurethan in einem oder mehreren organischen Lösungsmitteln weniger als 5 Gew.-%, bevorzugt weniger als 1 Gew.-%, besonders bevorzugt weniger als 0,3 Gew.-% Wasser bezogen auf das Gesamtgewicht der Lösung.

Wird nicht ausschließlich Polyurethan als filmbildendes Polymer eingesetzt, so können weiterhin andere Polymere gegebenenfalls in Form von Lösungen in einem oder mehreren organischen Lösungsmitteln mit eingesetzt werden, z.B. auf Basis von Polyestern, Poly(meth)acrylaten, Polyepoxiden, Polyvinylacetaten, Polyethylen, Polystyrol, Polybutadienen, Polyvinylchlorid und/oder entsprechenden Copolymerisaten.

Die erfindungsgemäß zu verwendenden Polymer-Lösungen können zusätzlich auch Hilfs- und Zusatzstoffe enthalten. Beispiele für solche Hilfs- und Zusatzstoffe sind Vernetzer, Verdicker, Colösemittel, Thixotropiermittel, Stabilisatoren, Antioxidantien, Lichtschutzmittel, Weichmacher, Pigmente, Füllstoffe, Hydrophobierungsmittel und Verlaufshilfsmittel.

Die erfindungsgemäß zu verwendenden Polymer-Lösungen können zusätzlich auch Füllstoffe enthalten, die die Dielektrizitätskonstante der Polymerschicht regulieren. Für bestimmte Anwendungen können Polymer-Lösungen ohne derartige Füllstoffe bevorzugt sein. Für andere Anwendungen können Polymer-Lösungen bevorzugt sein, die Zusätze von speziellen Füllstoffen zur Erhöhung der Dielektrizitätskonstanten, wie z.B. elektrisch leitfähige Füllstoffe oder Füllstoffe mit einer hohen Dielektrizitätskonstanten, enthalten. Beispiele für solche speziellen Füllstoffe sind Ruß, Graphit, einwandige oder mehrwandige KohlenstoffNanoröhrchen.

Additive zur Erhöhung der Dielektrizitätskonstante und/oder der Durchschlagsfeldstärke können auch nach Verfilmung noch zugesetzt werden, beispielsweise durch Erzeugung einer oder mehrerer weiteren Schicht(en) oder zur Durchdringung der Schicht.

Der Auftrag der erfindungsgemäß zu verwendenden Lösungen kann nach allen an sich bekannten Applikationsformen erfolgen, genannt seien beispielsweise Rakeln, Streichen, Gießen oder Sprühen.

Ein mehrschichtiger Auftrag mit gegebenenfalls zwischengelagerten Trocknungsschritten ist grundsätzlich auch möglich.

Für eine schnellere Trocknung und Fixierung werden bevorzugt Temperaturen oberhalb von 20°C benutzt. Bevorzugt werden Temperaturen zwischen 30 und 200°C. Sinnvoll ist auch eine zwei- oder mehrstufige Trocknung, mit entsprechend ansteigendem Temperaturgradienten, um eine Aufkochung der Polymerschicht zu verhindern. Die Trocknung erfolgt in der Regel unter Verwendung von an sich bekannten Heiz- und Trockenapparaten, wie (Umluft-) Trockenschränken, Heißluft oder IR-Strahlern. Auch die Trocknung durch Führen des beschichteten Substrates über geheizte Oberflächen, z.B. Walzen, ist möglich. Der Auftrag sowie die Trocknung können jeweils diskontinuierlich oder kontinuierlich durchgeführt werden, bevorzugt ist jedoch ein gänzlich kontinuierliches Verfahren.

Die mittels erfindungsgemäßer Verwendung der filmbildenden Zusammensetzungen hergestellte Polymerschicht kann mit weiteren Schichten versehen werden. Dies kann einseitig oder beidseitig geschehen, in einer Schicht oder in mehreren Schichten übereinander, durch vollständige oder durch flächig partielle Beschichtung des Films.

Als Trägermaterialien für die Herstellung der Polymerschicht eignen sich insbesondere Glas, Trennpapier, Folien und Kunststoffe, von denen die Polymerschicht gegebenenfalls wieder einfach entfernt werden kann. In bevorzugten Ausführungsformen der Erfindung wird als Trägermaterial für die Herstellung der Polymerschicht direkt eine der Elektroden für den herzustellenden Wandler verwendet, so dass ein nachträgliches Ablösen der Polymerschicht nicht mehr erforderlich ist.

Die Verarbeitung der einzelnen Schichten erfolgt durch Gießen oder händisches bzw. maschinell durchgeführtes Rakeln; auch Drucken, Siebdrucken und Spritzen bzw. Sprühen und Tauchen sind mögliche Verarbeitungstechniken. Generell sind alle Techniken denkbar, die bei einer Auftragung von dünnen Schichten - z.B. bei einer Lackierung - eingesetzt werden können.

Die Polymerschichten aus den filmbildenden Zusammensetzungen weisen eine gute mechanische Festigkeit und hohe Elastizität auf. Typischerweise sind die Werte für die Zugfestigkeit größer als 10 MPa und die Bruchdehnung ist größer als 250 %. Bevorzugt ist die Zugfestigkeit zwischen 10 und 100 MPa und die Bruchdehnung größer als 350 %.

Die Polymerschichten haben nach dem Trocknen typischerweise eine Dicke von 0,1 bis 1500 µm, bevorzugt 1 bis 500 µm, besonders bevorzugt 5 bis 200 µm, ganz besonders bevorzugt 5 bis 50 µm.

Zum Aufbau eines Energiewandlers werden die Polymerschichten beidseitig mit Elektroden beschichtet, wie beispielsweise in WO-A 01/06575 beschrieben. Sofern die Polymerschicht bereits auf einer Elektrode als Trägermaterial hergestellt wurde, ist nur noch die Beschichtung der anderen Seite mit einer weiteren Elektrode erforderlich.

Gegenstand der vorliegenden Erfindung ist daher weiterhin Verfahren zur Herstellung eines Wandlers zur Umwandlung von elektrischer Energie in mechanische Energie oder von mechanischer Energie in elektrische Energie, welcher mindestens zwei Elektroden und eine zwischen den Elektroden angeordneten Polymerschicht aufweist, dadurch gekennzeichnet, dass
a) eine Polymerschicht aus einer Lösung von wenigstens einem Polyurethan in einem oder mehreren organischen Lösungsmitteln hergestellt wird,
wobei
b1) die Polymerschicht entweder durch direktes Aufbringen der Lösung auf eine Elektrode hergestellt wird und anschließend von der anderen Seite mit einer weiteren Elektrode beschichtet wird oder
b2) die Polymerschicht nach Herstellung gemäß a) von beiden Seiten mit Elektroden beschichtet wird.

Bei den Elektrodenmaterialien kann es sich um dem Fachmann bekannte leitfähige Materialien handeln. Hierfür kommen beispielsweise Metalle, Metall-Legierungen, leitfähige Oligo- oder Polymere, wie z.B. Polythiophene, Polyaniline, Polypyrrole, leitfähige Oxide, wie z.B. Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierende Materialien, wie z.B. Russ, Kohlenstoffnanoröhrchen (Carbonanotubes (CNTs)), oder leitfähige Oligo- oder Polymere, in Frage. Der Füllstoffgehalt der Polymere liegt dabei oberhalb der Perkolationsschwelle, welche dadurch gekennzeichnet ist, dass die leitfähigen Füllstoffe durchgehende elektrisch leitfähige Pfade ausbilden. Vorzugsweise handelt es sich bei den mit leitfähigen Füllstoffen gefüllten Polymeren um Elastomere. Für besonders bevorzugte Anwendungen in denen die Elastizität des Gesamten Wandlers von Interesse ist, vorzugsweise geeignete Elektrodenmaterialien sind beispielsweise elastische Elektrodenmaterialien, wie z.B.leitfähige Oligo- oder Polymere oder mit leitfähigen Füllstoffen gefüllte Polymere.

Die Elektroden können mittels dem Fachmann bekannter Verfahren aufgebracht werden. Hierfür kommen beispielsweise Verfahren wie Sputtern, Aufdampfen, Chemical Vapor Deposition (CVD), Drucken, Rakeln, Spin-Coaten in Frage. Die Elektroden können auch in vorgefertigter Form aufgeklebt werden.

Die erfindungsgemäßen elektromechanischen Wandler enthalten mindestens zwei Elektroden. Bei elektromechanischen Wandlern mit mehr als zwei Elektroden kann es sich beispielsweise um Stapelaufbauten handeln. Bevorzugt sind elektromechanische Wandler enthaltend zwei Elektroden.

Die erfindungsgemäßen elektromechanischen Wandler enthaltend mindestens zwei Elektroden und wenigstens eine zwischen den Elektroden angeordnete Polymerschicht können in unterschiedlichsten Konfigurationen zur Herstellung von Sensoren, Aktuatoren oder Generatoren eingesetzt werden.

Gegenstand der vorliegenden Erfindung sind daher weiterhin Aktuatoren, Sensoren oder Generatoren enthaltend einen solchen erfindungsgemäßen Wandler bzw. eine Polymerschicht hergestellt aus einer Polyurethan-Lösung enthaltend wenigstens ein Polyurethan in einem oder mehreren organischen Lösungsmitteln sowie ein Verfahren zur Herstellung von Aktuatoren, Sensoren oder Generatoren unter Einsatz eines solchen erfindungsgemäßen Wandler bzw. einer Polymerschicht hergestellt aus einer Polyurethan-Lösung enthaltend wenigstens ein Polyurethan in einem oder mehreren organischen Lösungsmitteln.

Gegenstand der vorliegenden Erfindung sind weiterhin elektronische und elektrische Geräte, Vorrichtungen, Apparate, Bausteine, Automaten, Komponenten und Instrumente, die entsprechende Aktuatoren, Sensoren oder Generatoren enthalten.

Insbesondere die Generatoren und die Vorrichtungen enthaltend diese Generatoren können vorteilhaft für das so genannte "Energy Harvesting" verwendet werden, bevorzugt für die Umwandlung von Wasserwellenenergie in elektrischen Strom, besonders bevorzugt für die Umwandlung von Meereswellenenergie in elektrischen Strom.

Die folgenden Beispiele dienen der exemplarischen Erläuterung und Illustration der Erfindung und sind in keiner Weise als Beschränkung aufzufassen.

### Beispiele:

Sofern nicht abweichend gekennzeichnet, beziehen sich alle Prozentangaben auf das Gewicht.

Sofern nicht abweichend vermerkt, beziehen alle analytischen Messungen auf Temperaturen von 23°C.

Die Bestimmung der Festkörpergehalte erfolgte nach DIN-EN ISO 3251.

NCO-Gehalte wurden, wenn nicht ausdrücklich anders erwähnt, volumetrisch gemäß DIN-EN ISO 11909 bestimmt.

Die Kontrolle auf freie NCO-Gruppen wurde mittels IR-Spektroskopie (Bande bei 2260 cm⁻¹) durchgeführt.

Die angegebenen Viskositäten wurden mittels Rotationsviskosimetrie nach DIN 53019 bei 23°C mit einem Rotationsviskosimeter der Firma Anton Paar Germany GmbH, Ostfildern, DE bestimmt.

Die Einarbeitung von Füllstoffen in die erfindungsgemäßen Lösungen geschah mit einem Speedmixer (Modell 150 FV der Fa. Hauschild & Co KG, Postfach 4380, D-59039 Hamm).

Messungen der Filmschichtdicken wurden mit einem mechanischen Taster der Firma Heidenhain GmbH, Postfach 1260, D-83292 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 500 N nach DIN 53455 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit ZF in [MPa] und der Bruchdehnung BD in [%] noch die Spannung SP in [MPa] bei 100% (=SP100) und 200% (=SP200) Dehnung bestimmt.

Die Bestimmung des elektrischen Volumen-Widerstandes VW wurde mit einem Messaufbau der Firma Keithley Instruments Inc., 28775 Aurora Road, Cleveland, Ohio 44139, phone: (440) 248-0400, (Elektrometer : Modell-Nummer 6517A; Messkopf : Modell-Nummer 8009) und einem mitgelieferten Programm (Modell-Nummer 6524 : High Resistance Measurement Software) durchgeführt. Es wurde eine symmetrische, rechteckörmige Spannung von +/- 50 V für die Dauer von 4 min pro Periode für die Dauer von 10 Perioden angelegt und der Stromfluß bestimmt. Aus den Werten für den Stromfluß kurz vor Umschalten der Spannung wurde der Widerstand des Prüfkörpers bei jeder Periode der Spannung berechnet und gegen die Periodenanzahl aufgetragen. Der Endwert dieser Auftragung gibt den Messwert für den elektrischen Volumen-Widerstand der Probe an.

Messungen der Dielektrizitätskonstante DK wurden mit einem Messaufbau der Firma Novocontrol Technologies GmbH & Co. KG, Obererbacher Straße 9, 56414 Hundsangen /GERMANY, Phone: +49 6435 - 96 23 - 0 (Messbrücke : Alpha-A Analyzer, Messkopf: ZGS Active Sample Cell Test Interface) mit einem Durchmesser der Probekörper von 20 mm ausgeführt. Untersucht wurde dabei ein Frequenzbereich von 10⁷ bis 10⁻² Hz. Als Maß für die Dielektrizitätskonstante des untersuchten Materials wurde der Realteil der Dielektrizitätskonstante bei 10⁻² Hz gewählt.

Die Messungen der Wasseraufnahme (WL) wurden durch Lagerung der Polymerfolien für 72 h bei Raumtemperatur unter gesättigter Wasserfdampfatmosphäre in einem geschlossenen Gefäß ausgeführt. Dazu wird 1g der Polymerfolie präzise eingewogen und für 72 h in einem BOLA-Exsikkator (Modell V_1922, Produkt der Firma Bohlender GmbH, Waltersberg 8, D-97947 Grünsfeld) gelagert, der zusätzlich im unteren Bereich eine Schale mit Wasser enthält. Nach der 72 h dauernden Lagerung wurde die Folie aus dem Exsikkator entnommen und sofort gewogen. Die Gewichtsdifferenz bezogen auf das Ausgangsgewicht ist die Wasseraufnahme WL in %.

### Verwendete Substanzen und Abkürzungen:

| | |
|---|---|
| Diaminosulfonat: | NH₂-CH₂CH₂-NH-CH₂CH₂-SO₃Na (45 %ig in Wasser) |
| Desmophen^{®} 2020/C2200: | Polycarbonatpolyol, OH-Zahl 56 mg KOH/g, zahlenmittleres Molekulargewicht 2000 g/mol (Bayer MaterialScience AG, Leverkusen, DE) |
| Polyether LB 25: | monofunktioneller Polyether auf Ethylenoxid-/Propylenoxidbasis zahlenmittleres Molekulargewicht 2250 g/mol, OH-Zahl 25 mg KOH/g (Bayer MaterialScience AG, Leverkusen, DE) |
| PolyTHF^{®} 2000: | Polytetramethylenglykolpolyol, OH-Zahl 56 mg KOH/g, zahlenmittleres Molekulargewicht 2000 g/mol (BASF AG, Ludwigshafen, DE) |
| PolyTHF^{@} 1000: | Polytetramethylenglykolpolyol, OH-Zahl 112 mg KOH/g, zahlenmittleres zahlenmittleres Molekulargewicht 1000 g/mol (BASF AG, Ludwigshafen, DE) |

### Beispiel 1: Polymerschichten aus Polyurethan-Lösung (erfindungsgemäß)

200 g PolyTHF^{®} 2000 und 50 g PolyTHF^{®} 1000 wurden in einer Standard-Rührapparatur auf 80°C aufgeheizt. Anschließend wurde bei 80C innerhalb von 5 min ein Gemisch aus 66,72 g Isophorondiisocyanat und 520 g Methylethylketon zugegeben und am Rückfluss so lange gerührt (ca. 8 Stunden), bis der theoretische NCO-Wert erreicht war. Das fertige Prepolymer wurde auf 20°C abgekühlt und anschließend wurde eine Lösung aus 25,2 Methylenbis(4-aminocyclohexan) und 519,5 g Isopropanol innerhalb von 30 min zudosiert. Dann wurde weiter gerührt, bis IR-spektroskopisch keine freien Isocyanatgruppen mehr feststellbar waren.

Die erhaltene klare Lösung hatte nachfolgende Eigenschaften:

| | |
|---|---|
| Feststoffgehalt: | 25 % |
| Viskosität (Viskosimeter, 23°C): | 4600 mPas |

Die zur Herstellung jeweils einer Polymerschicht eingesetzte Lösung wurde nicht separat entgast. Die benötigte Menge von 100 g an erfindungsgemäßer Lösung wurde in einem Polypropylen-Becher (PP-Becher) eingewogen. Aus dem noch flüssigen Reaktionsgemisch wurden auf Glasplatten von Hand Schichten der Nassschichtdicke 1 mm gerakelt. Alle Schichten wurden nach der Herstellung bei 30°C im Trockenschrank über Nacht getrocknet und anschließend 5 min bei 120°C nachgetempert. Die Schichten konnten als Filme nach dem Tempern von Hand einfach von der Glasplatte gelöst werden.

### Beispiel 2 : Polymerschichten aus wässriger Polyurethan-Dispersion (Vergleichsbeispiel):

450 g PolyTHF^{®} 1000 und 2100 g PolyTHF^{®} 2000 wurden auf 70°C aufgeheizt. Anschließend wurde bei 70°C innerhalb von 5 min ein Gemisch aus 225,8 g Hexamethylendiisocyanat und 298,4 g Isophorondiisocyanat zugegeben und solange bei 100-115°C gerührt bis der theoretische NCO-Wert unterschritten war. Das fertige Prepolymer wurde mit 5460 g Aceton bei 50°C gelöst und anschließend eine Lösung aus 29,5 g Ethylendiamin, 143,2 g Diaminosulfonat und 610 g Wasser innerhalb von 10 min zudosiert. Die Nachrührzeit betrug 15 min. Danach wurde innerhalb von 10 min durch Zugabe von 1880 g Wasser dispergiert. Es folgte die Entfernung des Lösemittels durch Destillation im Vakuum und es wurde eine lagerstabile Dispersion erhalten.

| | |
|---|---|
| Feststoffgehalt: | 56 % |
| Partikelgröße (LKS): | 276 nm |
| Viskosität: | 1000 mPas |

Die eingesetzten Rohstoffe wurden nicht separat entgast. Die benötigte Menge von 100 g an Dispersion wurde in einem PP-Becher eingewogen. Aus dem noch flüssigen Reaktionsgemisch wurden auf Glasplatten von Hand Schichten der Nassschichtdicke 1 mm gerakelt. Alle Schichten wurden nach der Herstellung bei 30°C im Trockenschrank über Nacht getrocknet und anschließend 5 min bei 120°C nachgetempert. Die Schichten konnten als Filme nach dem Tempern von Hand einfach von der Glasplatte gelöst werden.

### Beispiel 3: Polymerschichten aus Zweikomponenten-Polyurethan-System (2k-PUR-System, Vergleichsbeispiel):

Alle flüssigen Rohstoffe wurden in einem dreistufigen Verfahren sorgfältig unter Argon entgast. 10g Terathane 650 (INVISTA GmbH, D-65795 Hatterheim, Poly-THF der Molmasse Mn = 650) wurde in einem 60 ml Einweg-Mischbehälter (APM-Technika AG, Best. Nr. 1033152) eingewogen. Anschließend wurde 0,005 g Dibutylzinndilaurat (Metacure® T-12, Air Products and Chemicals, Inc.) und 6,06 g des Isocyanates N3300 (das Isocyanurattrimere des HDI; Produkt der Bayer MaterialScience AG) dazu gewogen und 1 min bei 3000 Upm im Speedmixer vermischt. Das Reaktionprodukt wurde auf eine Glasplatte gegossen und mit einem Rakel der Nassschichtdicke 1 mm zu homogenen Schichten ausgezogen. Die Schichten wurden anschließend 16 h bei 80°C getempert und konnten nach dem Tempern als Filme von Hand von der Glasplatte abgezogen werden.

### Beispiel 4: Polymerschichten aus wässriger Polyurethan-Dispersion (Vergleichsbeispiel):

82,5 g PolyTHF^{®} 1000, 308 g PolyTHF^{®} 2000 und 10,0 g 2-Ethylhexanol wurden auf 70°C aufgeheizt. Anschließend wurde bei 70°C innerhalb von 5 min ein Gemisch aus 41,4 g Hexamethylendiisocyanat und 54,7g Isophorondiisocyanat zugegeben und solange bei 110-125°C gerührt bis der theoretische NCO-Wert unterschritten war. Das fertige Prepolymer wurde mit 880 g Aceton bei 50°C gelöst und anschließend eine Lösung aus 3,8 g Ethylendiamin, 4,6 g Isophorondiamin, 26,3 g Diaminosulfonat und 138 g Wasser innerhalb von 10 min zudosiert. Die Nachrührzeit betrug 15 min. Danach wurde innerhalb von 10 min durch Zugabe von 364 g Wasser dispergiert. Es folgte die Entfernung des Lösemittels durch Destillation im Vakuum und es wurde eine lagerstabile Dispersion erhalten.

| | |
|---|---|
| Partikelgröße (LKS): | 181 nm |
| Viskosität: | 1300 mPas) |

Die eingesetzten Rohstoffe wurden nicht separat entgast. Die benötigte Menge von 100 g an Dispersion wurde in einem PP-Becher eingewogen. Aus dem noch flüssigen Reaktionsgemisch wurden auf Glasplatten von Hand Schichten der Nassschichtdicke 1 mm gerakelt. Alle Schichten wurden nach der Herstellung bei 30°C im Trockenschrank über Nacht getrocknet und anschließend 5 min bei 120°C nachgetempert. Die Schichten konnten als Filme nach dem Tempern von Hand einfach von der Glasplatte gelöst werden.

### Beispiel 5: Polymerschichten aus wässrig-kolloidaler Polychloropren-Dispersion (Vergleichsbeispiel):

Es wurden 100 g einer unter dem Handelnamen Dispercoll^{®} C 84 kommerziell erhältlichen wässrig-kolloidalen Dispersion eines Polymerisates des 2-Chlorbutadiens mit einem Polymeranteil von 55 Gew.-%, einer Viskosität von ca. 100 mPas und einem pH-Wert von ca. 13 der Fa. Bayer MaterialScience AG, Leverkusen in einem PP-Becher eingewogen. Aus dem noch flüssigen Reaktionsgemisch wurden auf Glasplatten von Hand Schichten der Nassschichtdicke 1 mm gerakelt. Alle Schichten wurden nach der Herstellung bei 30°C im Trockenschrank über Nacht getrocknet und anschließend 5 min bei 120°C nachgetempert. Die Schichten konnten als Filme nach dem Tempern von Hand einfach von der Glasplatte gelöst werden.

### Daten der Filme:

| Filme | BD | ZF | SP100 | SP200 | VW | WL |
|---|---|---|---|---|---|---|
| | [%] | [MPa] | [MPa] | [MPa] | [Ohm-cm] | [%] |
| Bsp. 1 * | 540 | 33,5 | 2,94 | 3,88 | 4,5*10¹² | 0,93 |
| Bsp.2 | 620 | 26,6 | 2,2 | 2,7 | 7,3*10¹⁰ | 2,70 |
| Bsp.3 | 44 | 1,7 | - | - | 2,3*10¹¹ | 1,12 |
| Bsp.4 | 1432 | 3,4 | 0,46 | 0,58 | 4,8*10¹¹ | 8,99 |
| Bp. 5 | 793 | 22,4 | 3,2 | 4,1 | 1,1*10¹² | 10,52 |

| | | | | | | |
|---|---|---|---|---|---|---|
| *: erfindungsgemäß | | | | | | |

Es zeigte sich bei den Versuchen, dass Filme hergestellt unter erfindungsgemäßer Verwendung der Polyurethan-Lösungen deutliche Vorteile gegenüber solchen Filmen hergestellt aus Mehrkomponenten Polyurethan-Systemen oder wässrigen Polymer-Dispersionen bieten.

Besonders vorteilhaft bei Einsatz der Filme hergestellt unter erfindungsgemäßer Verwendung der Polyurethan-Lösungen sind die sehr guten mechanischen Eigenschaften wie hohe Elastizität, hohe Reißdehnung, gut geeigneter Spannungs-Dehnungs-Verlauf mit niedriger Spannung bei moderaten Dehnungen im Gebrauchsbereich der Anwendung, jedoch sehr hohe Zugfestigkeit, hohem elektrischem Widerstand und sehr geringer Wasseraufnahme. Unter guten mechanischen Eigenschaften waren im Rahmen der Erfindung eine Bruchdehnung (BD) von mindestens 250%, eine Zugfestigkeit (ZF) zwischen 10 und 100 MPa, zusätzlich eine sehr flache Spannungs-Dehnungskurve mit Spannungen unter 5 MPa bei moderaten Dehnungen im Bereich um 100% bis 200%, ein elektrischer Volumen-Widerstandes (VW) von mehr als 1*10¹² Ohm-cm bei einer Wasseraufnahme von unter 1 % zu verstehen. Bei den Vergleichsbeispielen war entweder eine Spannung bei 100% bzw. 200% nicht messbar, da diese Materialien bereits bei 40 % bis 60% gerissen sind oder die elektrische Leitfähigkeit war deutlich zu groß. Insbesondere zeigten die Vergleichsbeispiele eine deutlich zu hohe Wasseraufnahme (WL). Das erfindungsgemäße Beispiel zeigte hingegen eine besonders geringe Wasseraufnahme von unter 1%.

Weiterhin vorteilhaft an der Verwendung der Lösung ist die einfache Handhabung, da es sich hierbei um ein Einkomponenten(1K)-System handelt; es ist daher keine Handhabung reaktiver Gruppen wie z.B. freier Isocyanate beim Einarbeiten der Füllstoffe erforderlich.

## Patentansprüche

1. Verfahren zur Herstellung eines Wandlers zur Umwandlung von elektrischer Energie in mechanische Energie oder von mechanischer Energie in elektrische Energie, welcher mindestens zwei Elektroden und wenigstens eine zwischen den Elektroden angeordnete Polymerschicht aufweist, wobei die Polymerschicht aus einer Lösung enthaltend wenigstens ein Polyurethan in einem oder mehreren organischen Lösungsmitteln hergestellt wird, **dadurch gekennzeichnet, dass** die Lösung aus einem Prepolymerisationsverfahren mit folgenden Schritten stammt:
A) Herstellen von isocyanatfunktionellen Prepolymeren aus
A1) organischen Polyisocyanaten,
A2) polymeren Polyolen mit einem Molekulargewicht (Zahlenmittel) von 400 bis 8000 g/mol und einer mittleren OH-Funktionalität von 1,5 bis 6 und
A3) gegebenenfalls hydroxyfunktionellen Verbindungen mit Molekulargewichten von 62 bis 399 g/mol und
B) ganz oder teilweises Umsetzen der freien NCO-Gruppen des Prepolymeren aus A) mit
B1) aminofunktionellen Verbindungen mit Molekulargewichten von 32 bis 1000 g/mol,
wobei die Prepolymere vor, während und/oder nach Schritt B) in einem oder mehreren organischen Lösungsmitteln gelöst werden.

2. Verfahren gemäß Anspruch 1, **dadurch gekennzeichnet, dass** die Komponente A2) Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und Polyesterpolycarbonatpolyole, hydroxylgruppenaufweisende Polycarbonate, Polyether-Polycarbonatdiole oder Mischungen aus diesen, bevorzugt Polyetherpolyole, Polycarbonatpolyole oder Mischungen aus diesen, besonders bevozugt Polytetramethylenglykolpolyether enthält.

3. Verfahren gemäß Anspruch 1 oder 2, **dadurch gekennzeichnet, dass** die Komponente A1) difunktionelle Isocyanatbausteine, bevorzugt difunktionelle aliphatische Isocyanatbausteine, besonders bevorzugt Hexamethylendiisocyanat, die isomeren Bis-(4,4'-isocyanatocyclohexyl)methane und/oder Isophorondiisocyanat, und ganz besonders bevorzugt eine Mischung aus Hexamethylendiisocyanat und Isophorondiisocyanat enthält.

4. Verfahren gemäß wenigstens einem der Ansprüche 1 bis 3, **dadurch gekennzeichnet, dass** als Lösungsmittel Ester, Alkohole, Ketone, Ether, aromatische Lösungsmittel und/oder Amid- oder Harnstoffgruppen-haltige Lösungsmittel oder Mischungen enthaltend diese, bevorzugt Ester, Alkohole, Ketone und/oder Ether oder Mischungen enthaltend diese verwendet werden.

5. Verfahren gemäß wenigstens einem der Ansprüche 1 bis 4, **dadurch gekennzeichnet, dass** das Lösungsmittel bzw. Lösungsmittelgemisch wenigstens einen Alkohol enthält, bevorzugt der Gehalt an Alkoholen 10 bis 80 Gew.-% bezogen auf das Gesamtgewicht des Lösungsmittels bzw. Lösungsmittelgemisches beträgt.

6. Verfahren gemäß wenigstens einem der Ansprüche 1 bis 5, **dadurch gekennzeichnet, dass** die Lösung enthaltend wenigstens ein Polyurethan in einem oder mehreren organischen Lösungsmitteln weniger als 5 Gew.-%, bevorzugt weniger als 1 Gew.-%, besonders bevorzugt weniger als 0,3 Gew.-% Wasser bezogen auf das Gesamtgewicht der Lösung enthält.

7. Verfahren gemäß wenigstens einem der Ansprüche 1 bis 6, **dadurch gekennzeichnet, dass**
a) die Polymerschicht entweder durch direktes Aufbringen der Lösung auf eine Elektrode hergestellt wird und anschließend von der anderen Seite mit einer weiteren Elektrode beschichtet wird oder
b) die Polymerschicht nach Herstellung gemäß a) von beiden Seiten mit Elektroden beschichtet wird.

8. Wandler zur Umwandlung von elektrischer Energie in mechanische Energie oder von mechanischer Energie in elektrische Energie, welcher mindestens zwei Elektroden und wenigstens eine zwischen den Elektroden angeordneten Polymerschicht aufweist, **dadurch gekennzeichnet, dass** der Wandler nach einem Verfahren gemäß wenigstens einem der Ansprüche 1 bis 7 erhältlich ist.

9. Aktuator, Sensor oder Generator aufweisend wenigstens einen Wandler gemäß Anspruch 8.

10. Vorrichtungen, insbesondere elektronische und elektrische Geräte, die wenigstens einen Aktuator, Sensor oder Generator gemäß Anspruch 9 enthalten.

11. Verwendung eines Generators gemäß Anspruch 9 oder einer Vorrichtung gemäß Anspruch 10 zur Umwandlung von Wasserwellenenergie, bevorzugt von Meereswellenenergie in elektrischen Strom.

## Claims

1. Process for the production of a converter for conversion of electrical energy into mechanical energy or of mechanical energy into electrical energy, which comprises at least two electrodes and at least one polymer layer arranged between the electrodes, wherein the polymer layer is produced from a solution containing at least one polyurethane in one or more organic solvents, **characterized in that** the solution originates from a prepolymerization process with the following steps:
A) preparation of isocyanate-functional prepolymers from
A1) organic polyisocyanates,
A2) polymeric polyols having a molecular weight (number-average) of from 400 to 8000 g/mol and an average OH functionality of from 1.5 to 6 and
A3) optionally hydroxy-functional compounds having molecular weights of from 62 to 399 gmol and
B) complete or partial reaction of the free NCO groups of the prepolymers from A) with
B1) amino-functional compounds having molecular weights of from 32 to 1000 g/mol,
the prepolymers being dissolved in one or more organic solvents before, during and/or after step B).

2. Process according to claim 1, **characterized in that** component A2) comprises polyester polyols, polyacrylate polyols, polyurethane polyols, polycarbonate polyols, polyether polyols, polyester-polyacrylate polyols, polyurethane-polyacrylate polyols, polyurethane-polyester polyols, polyurethane-polyether polyols, polyurethane-polycarbonate polyols and polyester-polycarbonate polyols, polycarbonates containing hydroxyl groups, polyether-polycarbonate diols or mixtures of these, preferably polyether polyols, polycarbonate polyols or mixtures of these, particularly preferably polytetramethylene glycol polyethers.

3. Process according to claim 1 or 2, **characterized in that** component A1) comprises difunctional isocyanate units, preferably difunctional aliphatic isocyanate units, particularly preferably hexamethylene-diisocyanate, the isomeric bis-(4,4'-isocyanatocyclohexyl)methanes and/or isophoronediisocyanate, and very particularly preferably a mixture of hexamethylene-diisocyanate and isophoronediisocyanate.

4. Process according to at least one of claims 1 to 3, **characterized in that** esters, alcohols, ketones, ethers, aromatic solvents and/or solvents containing amide or urea groups or mixtures containing these, preferably esters, alcohols, ketones and/or ethers or mixtures containing these are used as the solvents.

5. Process according to at least one of claims 1 to 4, **characterized in that** the solvent or solvent mixture contains at least one alcohol, and preferably the content of alcohols is 10 to 80 wt. %, based on the total weight of the solvent or solvent mixture.

6. Process according to at least one of claims 1 to 5, **characterized in that** the solution containing at least one polyurethane in one or more organic solvents contains less then 5 wt. %, preferably less than 1 wt. %, particularly preferably less than 0.3 wt. % of water, based on the total weight of the solution.

7. Process according to at least one of claims 1 to 6, **characterized in that**
a) the polymer layer either is produced by direct application of the solution to an electrode and is then coated with a further electrode from the other side or
b) the polymer layer is coated with electrodes from both sides after production according to a).

8. Converter for conversion of electrical energy into mechanical energy or of mechanical energy into electrical energy, which comprises at least two electrodes and at least one polymer layer arranged between the electrodes, **characterized in that** the converter is obtainable by a process according to at least one of claims 1 to 7.

9. Actuator, sensor or generator comprising at least one converter according to claim 8.

10. Devices, in particular electronic and electrical equipment, which comprise at least one actuator, sensor or generator according to claim 9.

11. Use of a generator according to claim 9 or of a device according to claim 10 for the conversion of water wave energy, preferably sea wave energy, into electrical current.

## Revendications

1. Procédé pour la fabrication d'un convertisseur, destiné à convertir de l'énergie électrique en énergie mécanique ou de l'énergie mécanique en énergie électrique, qui présente au moins deux électrodes et au moins une couche polymère disposée entre les électrodes, la couche polymère étant préparée à partir d'une solution contenant au moins un polyuréthane dans un ou plusieurs solvants organiques, **caractérisé en ce que** la solution provient d'un procédé de prépolymérisation présentant les étapes suivantes :
A) préparation de prépolymères à fonctionnalité isocyanate à partir
A1) de polyisocyanates organiques,
A2) de polyols polymères présentant un poids moléculaire (moyenne numérique) de 400 à 8000 g/mole et une fonctionnalité OH moyenne de 1,5 à 6 et
A3) le cas échéant de composés à fonctionnalité hydroxy présentant des poids moléculaires de 62 à 399 g/mole et
B) transformation totale ou partielle des groupes NCO libres du prépolymère de A) avec B1
des composés à fonctionnalité amino présentant des poids moléculaires de 32 à 1000 g/mole,
les prépolymères étant dissous dans un ou plusieurs solvants organiques avant, pendant et/ou après l'étape B).

2. Procédé selon la revendication 1, **caractérisé en ce que** le composant A2) contient des polyesterpolyols, des polyacrylate-polyols, des polyuréthane-polyols, des polycarbonate-polyols, des polyéther-polyols, des polyester-polyacrylate-polyols, des polyuréthane-polyacrylate-polyols, des polyuréthane-polyester-polyols, des polyuréthane-polyéther-polyols, des polyuréthane-polycarbonate-polyols et des polyester-polycarbonate-polyols, des polycarbonates présentant des groupes hydroxyle, des polyéther-polycarbonatediols ou des mélanges de ceux-ci, de préférence des polyétherpolyols, des polycarbonate-polyols ou des mélanges de ceux-ci, de manière particulièrement préférée des polytétraméthylèneglycolpolyéthers.

3. Procédé selon la revendication 1 ou 2, **caractérisé en ce que** le composant A1) contient des éléments isocyanate difonctionnels, de préférence des éléments isocyanate aliphatiques difonctionnels, de manière particulièrement préférée de l'hexaméthylènediisocyanate, les bis-(4,4'-isocyanatocyclohexyl)méthanes isomères et/ou de l'isophoronediisocyanate, et de manière tout particulièrement préférée un mélange d'hexaméthylènediisocyanate et d'isophoronediisocyanate.

4. Procédé selon au moins l'une quelconque des revendications 1 à 3, **caractérisé en ce qu'**on utilise, comme solvants, des esters, des alcools, des cétones, des éthers, des solvants aromatiques et/ou des solvants contenant des groupes amide ou urée, ou des mélanges les contenant, de préférence des esters, des alcools, des cétones et/ou des éthers ou des mélanges les contenant.

5. Procédé selon au moins l'une quelconque des revendications 1 à 4, **caractérisé en ce que** le solvant ou, selon le cas, le mélange de solvants contient au moins un alcool, la teneur en alcools valant de préférence 10 à 80% en poids par rapport au poids total du solvant ou, selon le cas, du mélange de solvants.

6. Procédé selon au moins l'une quelconque des revendications 1 à 5, **caractérisé en ce que** la solution, contenant au moins un polyuréthane dans un ou plusieurs solvants organiques contient moins de 5% en poids, de préférence moins de 1% en poids, de manière particulièrement préférée moins de 0,3% en poids d'eau par rapport au poids total de la solution.

7. Procédé selon au moins l'une quelconque des revendications 1 à 6, **caractérisé en ce que**
a) la couche polymère est préparée soit par application directe de la solution sur une électrode, puis est revêtue sur l'autre face par une autre électrode, soit
b) la couche polymère est revêtue après la préparation selon a) sur les deux faces par des électrodes.

8. Convertisseur, destiné à convertir de l'énergie électrique en énergie mécanique ou de l'énergie mécanique en énergie électrique, qui présente au moins deux électrodes et au moins une couche polymère disposée entre les électrodes, **caractérisé en ce que** le convertisseur peut être obtenu selon un procédé selon au moins l'une quelconque des revendications 1 à 7.

9. Actionneur, capteur ou générateur présentant au moins un convertisseur selon la revendication 8.

10. Dispositifs, en particulier appareils électroniques et électriques qui contiennent au moins un actionneur, capteur ou générateur selon la revendication 9.

11. Utilisation d'un générateur selon la revendication 9 ou d'un dispositif selon la revendication 10 pour la conversion d'énergie de vagues, de préférence d'énergie de vagues océaniques en courant électrique.
